# EUROPEAN PATENT APPLICATION

(11) **EP 1 760 037 A1**
(43) Date of publication of application: **07.03.2007**
(21) Application number: 05255430.0
(22) Date of filing: 06.09.2005
(51) Int. Cl.: B81C 1/00

(54) **Method for manufacturing micromechanical structures.**

(71) Applicant: Infineon Technologies SensoNor AS, 3192 Horten (NO)
(72) Inventor: Jakobsen, Henrik, c/o SensoNor asa, 3192 Horten (NO)
(74) Representative: Haley, Stephen

(57) **Abstract**

A method for manufacturing a micromechanical structure is provided. A silicon substrate is provided, and the silicon substrate is etched to define a section upon which the micromechanical structure can be formed. A surface layer is formed on the surface of the substrate. Etching is then performed to form a micromechanical structure from the surface layer, and further etching releases the micromechanical structure from the substrate. A device comprising a micromechanical structure manufactured according to the method is also provided.

## Description

The present invention relates to the manufacture of micromechanical structures for use in micro electromechanical devices such as inertial devices. In particular, the invention relates to a method of manufacturing microstructures such as thin asymmetric springs, using bulk etching and bulk and/or surface micromachining techniques.

Micro electromechanical systems (MEMS) are becoming increasingly important in the manufacture of inertial devices such as angular rate sensors and multiple axis accelerometers. Micromechanical structures such as asymmetric springs, diaphragms and mass-spring systems are increasingly used in such devices, where these structures are used to obtain in-plane movements of structures when applying out-of-plane forces. The manufacturing methods of these structures generally involve bulk micromachining techniques.

Known devices which use such methods are realised by using the full wafer thickness of (100) silicon to define, for example, an asymmetric spring along the (111) plane by etching from both sides of the wafer. This results in thick springs in the range of 30 to 50 microns with a large spread in thickness, and a resulting large chip size. These methods strongly limit the downscaling of the dimensions of such springs, thereby limiting improvements in chip size and manufacturing costs.

Further prior art methods for manufacturing the asymmetric springs have aimed to reduce chip size using a combination of etch-stop against pn-junction techniques to form the thickness of the springs, a shallow wet etch to form the asymmetric feature and dry etching to release the springs from the manufacturing substrate. Such methods can produce springs with a practical thickness in the range of 10 to 20 microns, and a reduced width of approximately 5 microns (including the asymmetric cut).

Known devices which employ such methods include devices for measuring force components using monocrystalline materials, and 3-axis accelerometers. Devices for measuring angular velocity and angular rate sensors are also known to employ such micromechanical structures.

As mentioned above, limitations currently exist in the manufacturing methods of micromechanical structures such as asymmetric springs, and there is a need within the related industry to produce thinner structures in order to reduce the chip size of micromechanical devices, in a cost-effective manner.

The present invention seeks to overcome the aforementioned problems, by providing an alternative manufacturing method which can be used to build micromechanical structures such as thin asymmetric springs with a thickness in the sub-micron to 20 micron range and a width in the range of 1 micron or more, in an efficient and effective manufacturing method.

According to the present invention there is provided a method for manufacturing a micromechanical structure, the method comprising the steps of;
providing a silicon substrate;
etching the silicon substrate to define a section upon which the micromechanical structure can be formed;
forming a surface layer on the surface of the substrate;
etching to form a micromechanical structure from the surface layer; and
etching to release the micromechanical structure from the substrate.

Implementation of the present invention leads to the manufacture of much thinner asymmetric springs and related micromechanical structures, thereby providing greater flexibility in the manufacture of inertial devices in which in-plane movements of micromechanical structures occur when applying out-of-plane forces to the structures.

This method may also be employed when manufacturing parts for different types of actuators, for example parts for microvalves, micropumps, microgrippers, microhandling, microbiotics, etc.

Examples of the present invention will now be described with reference to the accompanying drawings, in which:
Figure 1 shows the manufacturing steps for thin asymmetric springs in single crystal silicon, using bulk etching and etch-stop against pn-junction techniques according to the present invention; and
Figure 2 shows the manufacturing steps for creating out-of-plane springs in poly-silicon or other thin-film material, according to the present invention.

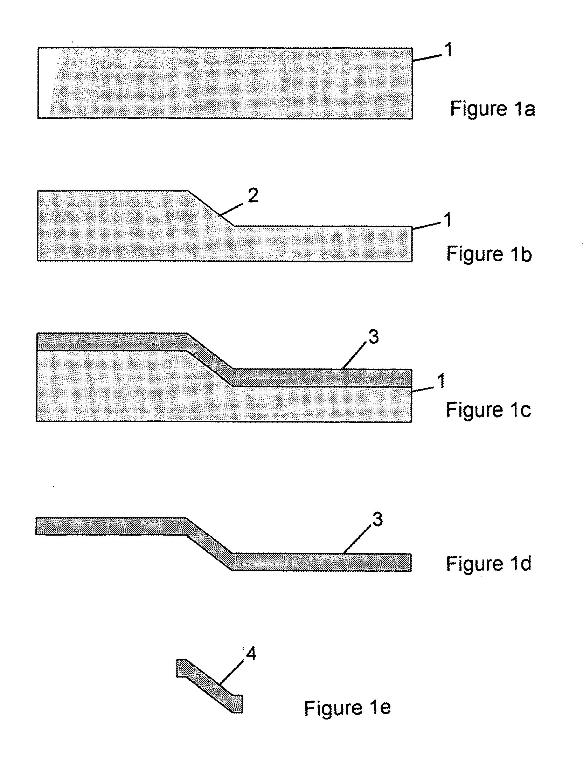

Referring to figure 1, the first step for manufacturing asymmetric springs in single crystal silicon according to one example of the invention is to provide a silicon substrate 1 on which the springs can be formed. In this example, the us of p-type silicon in the (100) plane is described, however other substrates such as (110) silicon can be used.

Next, an anisotropic etching technique is used to etch the section of the silicon substrate 1 in the (111) plane, defining a wall 2 along this plane as illustrated in figure 1 b.

Figure 1c illustrates the formation of a doped surface layer 3 on the substrate 1. The n-type surface layer 3 is built by ion implantation and diffusion, and lies across the (111) wall 2 etched on the silicon substrate 1. The surface layer 3 is then detached from the substrate 1 (figure 1d) using an etch-stop against pn-junction technique in order to form the asymmetric feature and thickness of an asymmetric spring 4.

Finally, it is necessary to release the asymmetric spring 4 from the remainder of the surface layer 3. This is done by standard photolithographic methods and dry-etching such as reactive ion etching (RIE), in order to create the length of the spring 4, which is shaped by the (111) silicon substrate wall 2. This produces an asymmetric spring 4 with a thickness in the sub-micron to 20 micron range, and a width in the range of one micron and above.

This example of the present invention uses a combination of anisotropic wet etching, doping by ion implantation, etch-stop against pn-junction and dry etching techniques to create thin asymmetric springs in single-crystal silicon. The bulk micromachining techniques described can then be combined with other processes to build complete sensor chips and other micromechanical devices, for example, methods for wafer level packaging, as described in European patent publication no. 1460037, can be employed in order to manufacture complete multiple axis inertial sensor chips packed on wafer level.

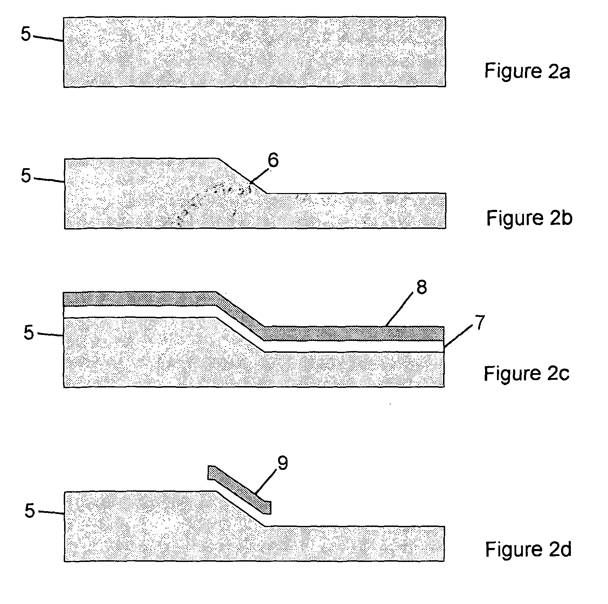

A further example of the manufacturing method of the present invention is illustrated in figure 2. This sequence of steps can be used to create out-of-plane asymmetric springs in poly-silicon or other deposited thin-film materials. Again, a p-type silicon substrate 5 in the (100) plane is provided on which to base the formation of the asymmetric springs. Anisotropic etching is performed to define a wall 6 along the (111) plane of the substrate 5 (figure 2b).

Next, a sacrificial layer 7 is created above the etched silicon substrate 5, as shown in figure 2c. The sacrificial layer 7 can be formed by thermal oxidation, or by depositing, for example, silicon dioxide onto the substrate 5. The sacrificial layer 7 can be composed of thermally grown silicon dioxide, deposited doped or undoped silicon dioxide, or other thin-film material that can be selectively removed and that can withstand the deposition temperature of the surface layer. A layer of, for example, poly-silicon 8, from which an asymmetric spring 9 will eventually be formed, is then deposited on the sacrificial layer 7 (figure 2c).

Finally, the poly-silicon layer 8 and sacrificial layer 7 are etched to form the asymmetric spring 9 and to release the micromechanical structure from the substrate 5, as shown in figure 2d.

The above steps therefore use a combination of bulk etching and surface-micromachining to create micromechanical structures such as thin asymmetric springs. This example of the present invention can be extended to build two-axis angular rate sensors and three-axis accelerometers as full single-chip structures.

The above examples of the invention are not limited to the realisation of springs along the (111) plane on (100) substrate; out-of-plane springs can also be manufactured by etchings at different angles to the substrate surface plane. For example, different angles can be created on the substrate by using isotropic etching and deep, near 90° vertical etching. Micro mechanical structures such as thin springs and mass-spring systems for inertial devices can be made with a large variety of geometries using the method of the present invention.

As alternatives to performing anisotropic etching initially on the substrate, wet isotropic etching can be used, resulting in curved elements, or dry RIE etching can be used.

Alternative thin-film materials to poly-silicon may be used in the present invention, including strong elastic dielectrics such as silicon-nitride, other semiconductor materials such as poly silicon germanium or silicon carbon, silicon-carbide, diamond-like-carbon and different metal films or insulating films which perform well as spring material, elastic thin-film materials such as Mo, W, Ti and Ni, and alloys including the shape-memory alloy TiNi.

The present invention therefore provides an efficient method of producing micromechanical structures such as thin asymmetric springs, which are a great deal thinner than those obtained by previous known methods. This allows for smaller, more compact and less expensive mircromechanical devices to be built with plates and asymmetric springs as required to obtain in-plane movements when applying out-of-plane forces, such as angular rate sensors and multiple axis accelerometers.

## Claims

1. A method for manufacturing a micromechanical structure, the method comprising the steps of;
providing a silicon substrate;
etching the silicon substrate to define a section upon which the micromechanical structure can be formed;
forming a surface layer on the surface of the substrate;
etching to form a micromechanical structure from the surface layer; and
etching to release the micromechanical structure from the substrate.

2. A method for manufacturing a micromechanical structure according to claim 1, wherein the silicon substrate is in the (100) plane.

3. A method for manufacturing a micromechanical structure according to claim 1 or 2, wherein the silicon substrate is anisotropically etched to define the (111) plane.

4. A method for manufacturing a micromechanical structure according to any of claims 1 to 3, the method further comprising the step of:
doping the surface of the substrate via ion implantation, such that diffusion occurs, in order to form the surface layer.

5. A method for manufacturing a micromechanical structure according to any preceding claim, the method further comprising the step of:
preforming an etch-stop against pn-junction technique to form an asymmetrical feature on to thickness of the micromechanical structure.

6. A method for manufacturing a micromechanical structure according to any preceeding claim, the method further comprising the step of;
dry-etching to release the micromechanical structure from the remainder of the surface layer.

7. A method for manufacturing a micromechanical structure according to any preceeding claim, wherein the surface layer is formed of single-crystal silicon.

8. A method for manufacturing a micromechanical structure according to any of claims 1 to 3, further comprising the step of;
forming a sacrificial layer between the silicon substrate and the surface layer via thermal oxidation.

9. A method for manufacturing a micromechanical structure according to any of claims 1 to 3, further comprising the step of;
forming a sacrificial layer via deposition of a material on the silicon substrate.

10. A method for manufacturing a micromechanical structure according to claim 8 or 9, wherein the surface layer is formed of one of poly silicon, SiC, Ti, Ni or TiNi.

11. A device comprising a micromechanical structure manufactured according to the method of the preceding claims.
